Europäisches Patentamt

European Patent Office

Office européen des brevets

(19)

(11) Publication number : **0 475 646 A2**

# (12) EUROPEAN PATENT APPLICATION

(21) Application number : **91307964.6**

(22) Date of filing : **30.08.91**

(51) Int. Cl.⁵ : **H01L 23/522**

(30) Priority : **12.09.90 GB 9019982**

(43) Date of publication of application :
**18.03.92 Bulletin 92/12**

(84) Designated Contracting States :
**DE FR IT NL**

(71) Applicant : **GEC-MARCONI LIMITED**
**The Grove, Warren Lane**
**Stanmore, Middlesex HA7 4LY (GB)**

(72) Inventor : **Saul, Peter Henry**
**51 Windsor Close**
**Towcester, Northants NN12 7JB (GB)**
Inventor : **White, Stephen James**
**1 Park Lane**
**Towcester, Northants NN12 7NF (GB)**

(74) Representative : **Pope, Michael Bertram**
**Wingate**
**The General Electric Company, p.l.c., GEC**
**Patent Dept.(Wembley Office), Hirst Research**
**Centre, East Lane**
**Wembley Middlesex HA9 7PP (GB)**

(54) Semiconductor integrated circuit comprising interconnections.

(57)  A semiconductor integrated circuit chip is provided comprising a substrate 1, a dielectric layer 3, deposited on the substrate 1 and one or more conductive tracks 4, 5 formed on the dielectric layer 3, at least part of the dielectric layer 3 which is along at least one edge of the conductive tracks 4, 5 and which is adjacent to the part of the dielectric layer 3 which underlies the conductive track 4, 5 being etched away to form an air gap 16 in the region where fringing fields and/or lateral fields exist, thereby to reduce the stray interconnection capacitance between the conductive tracks 4,5 and the substrate 1.

EP 0 475 646 A2

Jouve, 18, rue Saint-Denis, 75001 PARIS

Figure 3

This invention relates to semiconductor integrated circuit arrangements.

As integrated circuit chips are scaled down to smaller and smaller dimensions, interconnection capacitances have become a major problem. The use of smaller devices operating at lower currents means that track driving capability is more limited. Although with scaling down it would be expected that track lengths would be getting shorter, with improving technology it is being found that chips of larger size and complexity can be made so that track lengths are, in fact, increasing. Reducing track widths, also normally carried out when a circuit is scaled down, is of limited help because for dielectrics of comparable thickness to the track spacing, "fringing fields" in the dielectric are a major source of interconnection capacitance. The position is worse where there are both laterally spaced and vertically spaced track runs because interconnection capacitances will exist both laterally and vertically between the tracks. In general, multi-layer busses of many tracks width would be used on a complex digital chip, and all would be coupled capacitively to their immediately adjacent tracks and to the more remote tracks.

Possible solutions for reducing the effects of interconnection capacitances are to increase the dielectric thickness which is clearly a retrograde step and not conducive with scaling down requirements or to reduce the dielectric constant (e) of the dielectric material. Dielectric materials suitable for integrated circuit manufacture conventionally have a dielectric constant of 3.5 to 4.0 (polyimide having e = 3.5 and SiO2 having e = 3.9). Dielectric materials having a lower dielectric constant e.g. resins (e = 2.6) or Teflon (e = 1.9) are at the present time unproven and not in widespread use.

It is an object of the present invention to provide a semiconductor integrated circuit chip in which the interconnection capacitances are reduced.

According to one aspect of the present invention there is provided a semiconductor integrated circuit arrangement comprising a first conductive region, a dielectric layer disposed over said first conductive region and a conductive track disposed on said dielectric layer, in which at least part of the dielectric layer which is along at least one edge of said conductive track and which is adjacent to the part of the dielectric layer which underlies said conductive track is removed to reduce the interconnection capacitance between said conductive track and said first conductive region.

In a preferred arrangement, a part of the dielectric layer which underlies said conductive track is also removed to further reduce said interconnection capacitance.

In carrying out the invention it may be arranged that said first conductive region is constituted by the semiconductor substrate of said arrangement, or is constituted by a further conductive track over which said dielectric layer is deposited.

Preferably the said part of said dielectric layer which is removed is removed by etching, and the said part of said dielectric layer which is removed by etching is preferably defined by said conductive track.

Advantageously, said conductive track is formed as part of a metallisation layer of said arrangement, in which case it may be arranged that said metallisation layer comprises a plurality of conductive tracks disposed substantially adjacent to one another, and in which the dielectric layer between said tracks is removed to reduce the interconnection capacitance therebetween and between said conductive tracks and said first conductive region.

It may also be arranged that said arrangement comprises a plurality of superposed metallisation layers separated by respective dielectric layers, in which case it may be arranged that at least part of each of the respective dielectric layers is removed in dependence upon said respective metallisation layers.

According to a second aspect of the present invention there is provided a method of making a semiconductor integrated circuit arrangement comprising the steps of providing a first conductive region, depositing a dielectric layer over said first conductive region, providing a conductive track on said dielectric layer, and removing at least part of the dielectric layer which is along at least one edge of said conductive track and which is adjacent to the part of the dielectric layer which underlies said track, thereby reducing the interconnection capacitance between said conductive track and said conductive region.

An exemplary embodiment of the invention will now be described reference being made to the accompanying drawings, in which:

Figure 1, is a cross-sectional side view of part of a prior art semiconductor integrated circuit chip;

Figure 2, is a cross-sectional side view of part of a semiconductor integrated circuit chip in accordance with the present invention; and

Figure 3, is a cross-sectional side view of an improved form of the semiconductor integrated circuit chip of Figure 2 in accordance with the present invention.

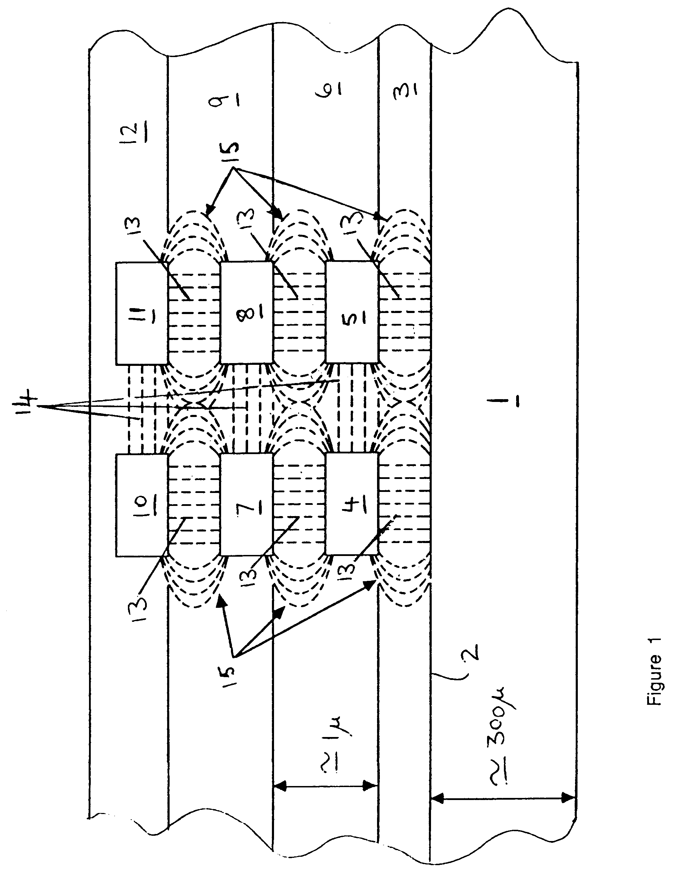

In Figure 1 of the drawings there is shown a cross-sectional side view of part of a prior art semiconductor integrated circuit chip comprising a semiconductor substrate 1 on which would be formed, using conventional integrated circuit technology, a plurality of passive and/or active devices (not shown) in accordance with a required circuit operation. On to the surface 2 of the substrate 1 is formed a three-level deep metal track system for interconnecting the active and passive devices on the substrate 1. The track system comprises a first dielectric layer 3 on which is deposited a first metallisation layer which is selectively etched in known manner to afford two parallel disposed conductive tracks 4 and 5. A second dielectric layer 6 is formed over the top of the conductive tracks 4 and 5, on which is deposited a second metallisation layer which is selectively etched to afford two further parallel disposed conductive tracks 7 and 8 which are disposed over respective ones of the conductive tracks 4 and 5. A third dielectric layer 9 is formed over the top of the conductive tracks 7 and 8, on which is deposited a third metallisation layer which is selectively etched to afford two further parallel disposed conductive tracks 10 and 11 which are also disposed over respective ones of the conductive tracks 7 and 8. The conductive tracks 4, 5, 7, 8, 10 and 11 might typically form an interconnection bus on the substrate 1 and it should be appreciated that in a complex digital chip the interconnection bus might comprise many more conductive tracks disposed above and/or alongside those shown. Over the conductive tracks 10 and 11 is formed a further dielectric layer 12.

It will be appreciated that the semiconductor integrated circuit chip shown in Figure 1 is not to scale and typically the substrate 1 may have a thickness of 300 microns (u) whereas the interconnection bus comprising the conductive tracks would typically be based on 1 micron geometry with the dielectric layers 6, 9 and 12 being 1 micron thick and the size and spacing of the conductive tracks 4, 5, 7, 8, 10 and 11 being sized accordingly.

As is indicated in Figure 1, stray interconnection capacitances exist between adjacent pairs of the conductive tracks 4, 5, 7, 8, 10 and 11 and between the conductive tracks 4 and 5 and the substrate 1, as indicated by the dashed vertical field lines 13 and the dashed lateral field lines 14. The stray interconnection capacitances are also effectively increased due to the fringing fields 15 existing between the conductive tracks themselves and between the conductive tracks 4 and 5 and the substrate 1 and typically it has been found that the fringing fields 15 together with the lateral fields 14 can more than double the stray capacitance that would otherwise exist.

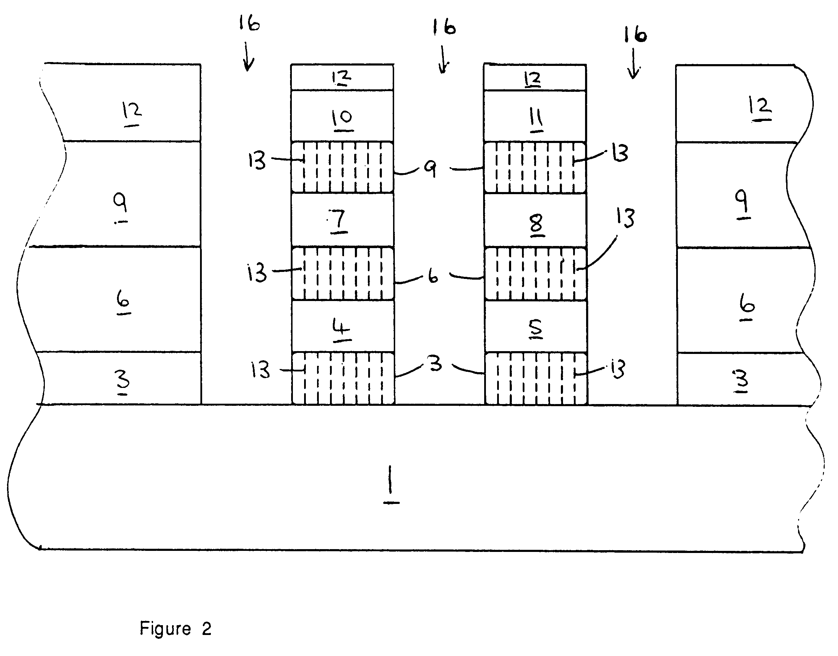

It is proposed in accordance with the present invention to minimise the effects that the fringing fields 15 and lateral fields 14 have on the stray interconnection capacitance and this is achieved as is shown in Figure 2 of the drawings by etching away parts of the dielectric layers 3, 6, 9 and 12 to form air gaps 16 between the vertical stacks of conductive tracks 4, 7, 10 and 5, 8, 11. In this way, although fringing fields 15 and lateral fields 14 will still exist between respective pairs of the conductive tracks 4, 5, 7, 8, 10 and 11 and between the conductive tracks 4 and 5 and the substrate 1, these will now exist in air which has a dielectric constant e substantially equal to unity compared to the dielectric constant e of between 3.5 and 4.0 of the dielectric layers 3, 6, 9 and 12, with the result that the stray capacitances will be substantially reduced, possibly by a factor of two or more. It may conveniently be arranged that the conductive tracks 4, 5, 7, 8, 10 and 11 themselves are used as the mask for etching the dielectric layers 3, 6, 9 and 12 thereby obviating the need for a separate masking layer to form the air gaps 16. Where the final metallisation layer which forms the conductive tracks 10 and 11 has a large area coverage, it may be necessary to provide gaps in the coverage to permit etching of the dielectric layers below. It may also be arranged that the air gaps 15 are filled with a suitable package filling gas such as nitrogen.

An overall passivation layer (not shown) may be deposited on the chip, after the air gaps 16 have been etched, the layer necessarily being of a material and thickness which would not back-fill the gaps 16. The deposition could use a plasma enhanced CVD process, and a possible final layer may be of a high surface tension plastics material which will not flow into the gaps 16.

Although in Figure 2 there is shown part of an integrated circuit chip in which the conductive tracks 4, 5, 7, 8, 10 and 11 take the form of an interconnection bus, it should be appreciated that the technique of removing at least part of a dielectric layer in which fringing fields and/or lateral fields exist has a much wider application and may be used in chips having one or more metallisation layers and may be used in chips which have single or multiple track busses.

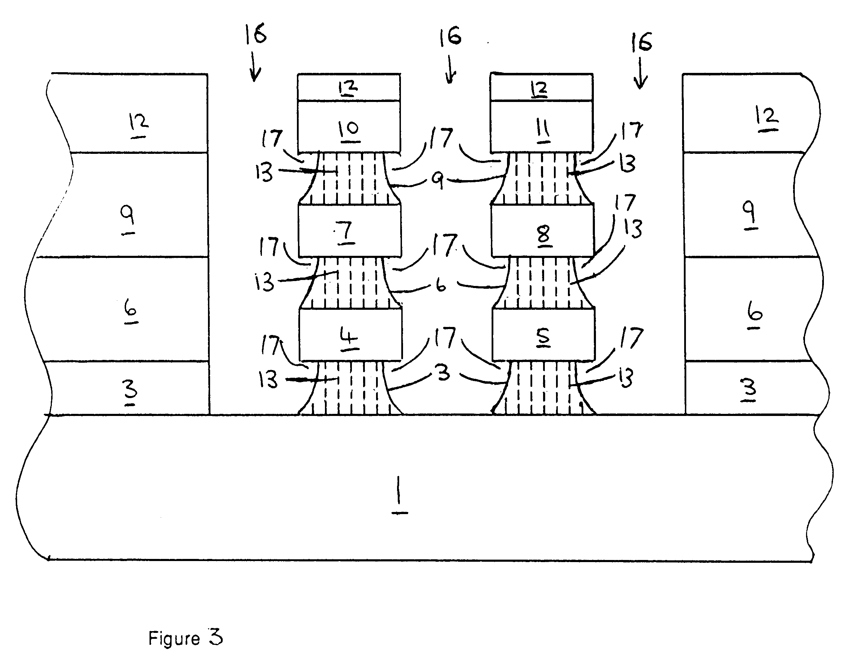

In Figure 3 of the drawings there is depicted an improved form of the integrated circuit chip depicted in Figure 2 in which the dielectric layers 3, 6, 9 and 12 are each isotropically etched whereby the part of the dielectric layers under the actual conductive tracks 4, 5, 7, 8, 10 and 11 are removed, as shown at 17, to reduce the amount of dielectric material between the tracks thereby to further reduce the stay capacitances between them.

It should be appreciated that in the foregoing embodiments, any means of etching may be used, anisotropic or isotropic, provided a mechanically stable chip structure is obtained.

## Claims

1. A semiconductor integrated circuit arrangement comprising a first conductive region, a dielectric layer disposed over said first conductive region and a conductive track disposed on said dielectric layer, in which at least part of the dielectric layer which is along at least one edge of said conductive track and which is adjacent to the part of the dielectric layer which underlies said conductive track is removed to reduce the interconnection capacitance between said conductive track and said first conductive region.

2. An arrangement as claimed in claim 1, in which part of the dielectric layer which underlies said conductive track is also removed to further reduce said interconnection capacitance.

3. An arrangement as claimed in claim 1 or claim 2, in which said first conductive region is constituted by the semiconductor substrate of said arrangement.

4. An arrangement as claimed in claim 1 or claim 2, in which said first conductive region is constituted by a further conductive track over which said dielectric layer is deposited.

5. An arrangement as claimed in any preceding claim, in which the said part of said dielectric layer which is removed is removed by etching.

6. An arrangement as claimed in claim 5, in which the said part of said dielectric layer which is removed by etching is defined by said conductive track.

7. An arrangement as claimed in any preceding claim, in which said conductive track is formed as part of a metallisation layer of said arrangement.

8. An arrangement as claimed in claim 7, in which said metallisation layer comprises a plurality of conductive tracks disposed substantially adjacent to one another, and in which the dielectric layer between said tracks is removed to reduce the interconnection capacitance therebetween and between said conductive tracks and said first conductive region.

9. An arrangement as claimed in claim 7 and claim 8, comprising a plurality of superposed metallisation layers separated by respective dielectric layers.

10. An arrangement as claimed in claim 9, in which at least part of each of the respective dielectric layers is removed in dependence upon said respective metallisation layers.

11. A method of making a semiconductor integrated circuit arrangement comprising the steps of providing a first conductive region, depositing a dielectric layer over said first conductive region, providing a conductive track on said dielectric layer, and removing at least part of the dielectric layer which is along at least one edge of said conductive track and which is adjacent to the part of the dielectric layer which underlies said track, thereby reducing the interconnection capacitance between said conductive track and said conduc-

tive region.

Figure 1

16   16   16

12   10   12   11   12

13   9   13   9

7   8

13   6   13   13

6

13   4   3   13   5   13

3   3

1

Figure 2

EP 0 475 646 A2

16    16    16

12    12    12

12    10    11    9

17    17    17

13    9    13

9    7    8    9

17    17    17

13    6    13

6    7    8    6

17    17    17

13    4    5    13

3    4    5    3

1

Figure 3